(19) Europäisches Patentamt
European Patent Office
Office européen des brevets

(11) Publication number : **0 674 225 A1**

(12) # EUROPEAN PATENT APPLICATION

(21) Application number : **95301656.5**

(22) Date of filing : **14.03.95**

(51) Int. Cl.[6] : **G03F 7/027,** C08G 18/44

(30) Priority : **16.03.94 JP 44584/94**
**16.03.94 JP 45642/94**

(43) Date of publication of application :
**27.09.95 Bulletin 95/39**

(84) Designated Contracting States :
**DE FR GB IT NL**

(71) Applicant : **HITACHI CHEMICAL COMPANY, LTD.**
**1-1, 2-chome, Nishishinjuku**
**Shinjuku-ku**
**Tokyo 163 (JP)**

(72) Inventor : **Tsuchiya, Katsunori**
**6-18, Takasuzucho-2-chome**
**Hitachi-shi (JP)**
Inventor : **Yoshida, Tetsuya**
**10-4, Higashitagacho-4-chome**
**Hitachi-shi (JP)**
Inventor : **Yamazaki, Hiroshi**
**7-55, Nishinarusawacho-4-chome**
**Hitachi-shi (JP)**
Inventor : **Watanabe, Mituaki**
**Yamasakiryo, 2-9, Higashicho-4-chome**
**Hitachi-shi (JP)**

(74) Representative : **Marshall, Monica Anne**
**J.A. KEMP & CO.**
**14 South Square**
**Gray's Inn**
**London WC1R 5LX (GB)**

(54) **Photosensitive resin composition and photosensitive film.**

(57) A photosensitive resin composition comprising (a) at least one ethylenically unsaturated group-containing polymerizable compound including at least one compound obtained by addition reaction of a polycarbonate diol, or copolycarbonate diol, a compound having two isocyanate groups and a compound having a hydroxyl group and an acryloyl group in the molecule, (b) a thermoplastic polymer having carboxyl groups, and (c) a photopolymerization initiator capable of generating free radicals upon exposure to activic light, is excellent in processability, flexibility and solder heat resistance, and can provide a flexible photosensitive film.

EP 0 674 225 A1

## BACKGROUND OF THE INVENTION

The present invention concerns a photosensitive resin composition and more specifically, it relates to a photosensitive resin composition suitable for forming a protective film (a cover layer) that can be used in the production of, for example, a flexible printed wiring board, and a photosensitive film using the same.

Heretofore, liquid- or film-like photosensitive resin compositions have been used in the production of printed wiring boards, which are used, for example, as etching resist for copper foil of copper-clad laminates or with an aim of defining a soldering position and protecting wirings formed on printed circuit boards.

Printed circuit boards include film-like boards that can be bent and incorporated into small-sized equipments such as cameras, said flexible film-like boards being referred to as FPC (Flexible Printed Circuit). FPCs also require a resist for defining the soldering position and protecting wirings, said resist being called as a cover layer or cover coat. The cover layer is formed by punching a polyimide or polyester film having an adhesive layer thereon into a predetermined pattern and then hot press bonding on FPC. The cover coat is formed by printing and curing a thermocurable or light-curable ink.

Flexibility is a particularly important property for such resist used for the aim of defining the soldering position and protecting wirings of FPC. For this purpose, polyimide cover layers with excellent flexibility are often used. However, the cover layer requires an expensive mold for die punching, gives low yield because of manual lamination of punched films and sticking out of adhesives, resulting in an increase of production cost to bar enlargement of FPC market. In addition, it is difficult to meet the recent requirement for higher density.

In view of the above, there has been demanded a photosensitive resin composition, particularly, a photosensitive film, suitable for forming a cover layer with high accuracy and high reliability and excellent in dimensional accuracy and resolution power in a photographic developing method (a method of forming images by development subsequent to imagewise exposure).

For this purpose, it has been attempted to use photosensitive resin compositions for forming a solder mask. There have been disclosed, for example, a light sensitive resin composition mainly composed of an acrylic polymer and a photopolymerizable monomer (Japanese Patent Unexamined Publication (JP-A) Nos. 53-56018, 54-1018, etc.), a composition mainly composed of a photosensitive epoxy resin having chalconic groups on the main chain and a curing agent for the epoxy resin as a photosensitive resin composition with satisfactory heat resistance (JP-A Nos. 54-82073, 58-62636, etc.), a composition mainly composed of a novolac type epoxy acrylate containing epoxy groups and a photopolymerization initiator (JP-A No. 61-272, etc.) and a composition mainly composed of a carboxyl group-containing polymer, a monomer, a photopolymerization initiator and a thermosetting resin as a photosensitive resin composition for forming a solder mask that can be developed with an aqueous alkali solution which is excellent in safety and economical viewpoint (JP-A Nos. 48-73148, 57-178237, 58-42040, 59-151152, etc.), but none of them has sufficient flexibility.

## SUMMARY OF THE INVENTION

It is an object of the present invention to provide a photosensitive resin composition having satisfactory workability and excellent in flexibility and soldering heat resistance, as well as a photosensitive film using the same, overcoming the drawbacks mentioned above.

The present invention provides a photosensitive resin composition developable with an aqueous alkali solution, which comprises

(a) at least one ethylenically unsaturated group-containing polymerizable compound including at least one polymerizable compound represented by the formula:

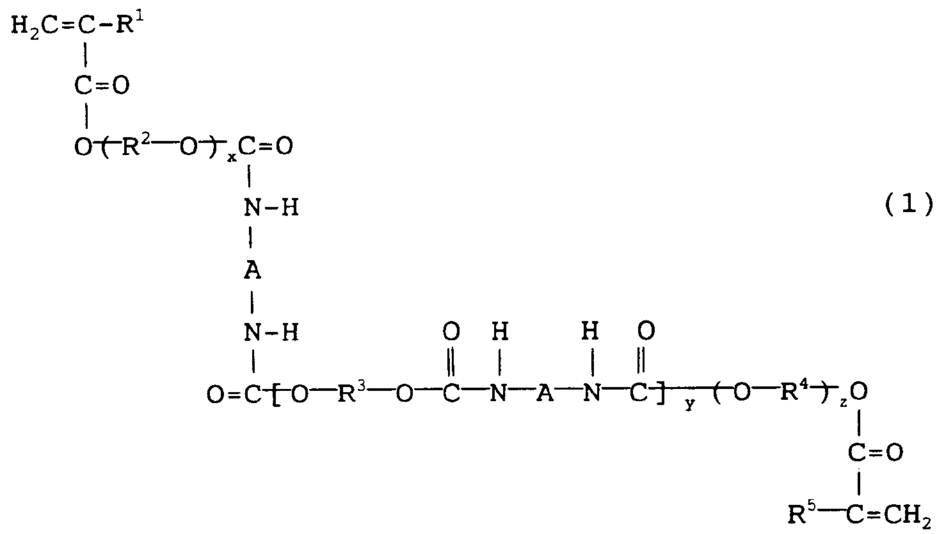

(1)

wherein A represents an alkylene group having 2 to 12 carbon atoms, a vinylene group, a group of the formula:

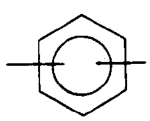 , 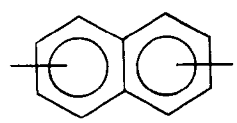 ,

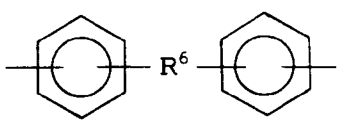 or 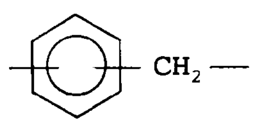

(in which $R^6$ represents a methylene group or an imino group), or a 1-methylene-1,3,3-trimethylcyclohexane-5-yl group; $R^1$ and $R^5$ each represents independently a hydrogen atom or a methyl group; $R^2$ and $R^4$ each represents independently an alkylene group having 2 to 8 carbon atoms; $R^3$ represents a divalent residue of polycarbonate diol or copolycarbonate diol, of which hydroxyl groups are detached from the both ends; x and z each represents independently an integer of 1 to 20; and y represents an integer of 1 to 100,

(b) a thermoplastic polymer having carboxyl groups, and

(c) a photopolymerization initiator capable of generating free radicals upon exposure to actinic light.

The present invention also provides a photosensitive film comprising a layer of the photosensitive resin composition mentioned above formed on a support film.

BRIEF DESCRIPTION OF THE DRAWING

The attached drawing is a schematic view of an apparatus for producing a photosensitive film used in the Examples.

DESCRIPTION OF THE PREFERRED EMBODIMENTS

The photosensitive resin composition of the present invention comprises

(a) at least one ethylenically unsaturated group-containing polymerizable compounds including at least one polymerizable compound of the formula:

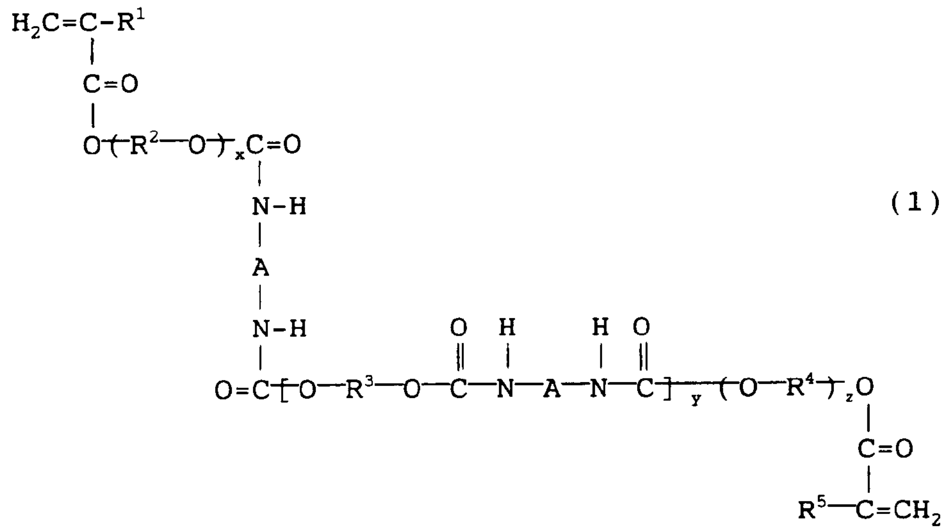

(1)

(b) a thermoplastic polymer having carboxyl groups, and

(c) a photopolymerization initiator capable of generating free radicals upon exposure to actinic light.

The photosensitive resin composition according to the present invention contains, as the essential component (a), a polymerizable compound containing urethane linkage and represented by the formula (1).

In the formula (1), the alkylene group having 2 to 12 carbon atoms represented by A can include, for example, an ethylene group, an n-propylene group, an isopropylene group, an n-butylene group, an isobutylene group, a pentylene group, a neopentylene group, a hexylene group, a heptylene group, an n-octylene group, a 2-ethylhexylene group, a nonylene group, a decylene group, an undecylene group and a dodecylene group. It is difficult to obtain the materials having carbon atoms of 1 or 13 or greater. The alkylene group having 2 to 12 carbon atoms, a vinylene group, a group of the formula

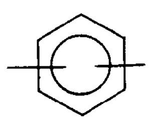

,

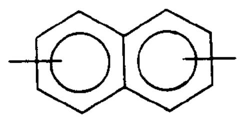

,

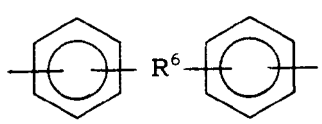

or

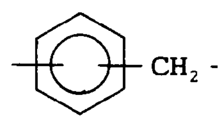

(in which $R^6$ represents a methylene group or an imino group), or a 1-methylene-1,3,3-trimethylcyclohexane-5-yl group represented by A may be non-substituted or substituted with one or more alkyl groups having 1 to 8 carbon atoms, alkoxy groups having 1 to 8 carbon atoms or halogen atoms. Further, an aromatic ring of the above aromatic group may be hydrogenated.

In the formula (1), the alkylene group having 2 to 8 carbon atoms represented by $R^2$ or $R^4$ can include, for example, an ethylene group, an n-propylene group, an isopropylene group, an n-butylene group, an isobutylene group, a pentylene group, a neopentylene group, a hexylene group, a heptylene group, an n-octylene group and a 2-ethylhexylene group. It is difficult to obtain the materials having carbon atoms of 1 or 9 or greater.

The divalent residue of a polycarbonate diol or copolycarbonate diol represented by $R^3$, of which hydroxyl groups are detached from the both ends, in the formula (I) has a structure wherein alkylene groups are bound to a main chain via a carbonate linkage. Such a divalent residue can be obtained from polycarbonate diols or copolycarbonate diols obtained by reacting with the following diol compounds by a conventional method (e.g. a phosgen method, etc.).

As the diol compounds, there can be use diethylene glycol, triethylene glycol, tetraethylene glycol, tripropylene glycol, polypropylene glycol, etc.; ethylene glycol, 1,2-propanediol, 1,3-butanediol, 1,4-butanediol, 2-methyl-1,3-butanediol, neopentyl glycol, 2-methylpentanediol, 3-methyl-pentanediol, 2,2,4-trimethyl-1,6-hexanediol, 3,3,5-trimethyl-1,6-hexanediol, 2,3,5-trimethylpentanediol, 1,6-hexanediol, 1,5-pentanediol, etc., singly or as a mixture thereof. It is possible to include one or more polyol compounds such as trimethylolpropane, trimethylolethane, hexanetriol, heptanetriol, pentaerythritol, etc.

The subscripts x and z in the formula (1) represent independently integers of 1 to 20, respectively. It is difficult to obtain the materials, if x or z represents 0 or an integer of 21 or greater.

The subscript y in the formula (1) represents an integer of 1 to 100. If y is 0, no sufficient flexibility is obtained as the cover layer and, if it is 101 or greater, no sufficient photopolymerizability is obtained to reduce the sensitivity.

The weight average molecular weight of the polymerizable compound represented by the formula (1) is preferably from 1,000 to 50,000 in view of the flexibility, the photopolymerizability and the like.

The compound represented by the formula (1) can be obtained by addition reaction of at least one polycarbonate diol (for example, tetramethylene carbonate, pentamethylene carbonate or hexamethylene carbonate is used as a repeating unit), at least one compound having two isocyanate groups (for example, one of ethylene diisocyanate, propylene diisocyanate, butylene-1,3-diisocyanate, 1,6-hexamethylene diisocyanate, 2,2,4-trimethyl-1,6-hexamethylene diisocyanate, 2,4-dimethyl-6-ethyloctamethylene diisocyanate, cyclohexylene diisocyanate, cyclopentylene diisocyanate, 1,4-diisocyanate methylcyclohexane, 1,3-diisocyanate ethylcyclohexane, isophorone diisocyanate, 2,4-tolylene diisocyanate, 2,6-tolylene diisocyanate, 4,4'-diphenylmethane diisocyanate, dianisidine diisocyanate, tridene diisocyanate, methaxylylene diisocyanate, 1,5-naphthalene diisocyanate, transvinylene diisocyanate, 2,6-diisocyanate methylcaproate, hydrogenated tolylene diisocyanate, hydrogenated xylylene diisocyanate, dimer of tolylene diisocyanate, and a trimer of tolylene diisocyanate), and at least one compound having a hydroxyl group and an acryloyl group in the molecule (for example, one of 2-hydroxyethyl acrylate, 2-hydroxyethyl methacrylate, n-hydroxyethyl methacrylate, iso-hydroxyethyl methacrylate, 2-hydroxybutyl methacrylate, 4-hydroxybutyl methacrylate, trimethylolethane diacrylate, trimethylolpropane dimethacrylate, pentaerythritol triacrylate, pentaerythritol trimethacrylate, diethyleneglycol monoacrylate, triethyleneglycol monomethacrylate, hexaethylene glycol monomethacrylate and other polyethyleneglycol monomethacrylate having upto 20 oxyalkylene units, known reaction products of an alkylene oxide, particularly, ethylene oxide having about 1 to 15 oxyalkylene units with, for example, trimethylolpropane dimethacrylate, pentaerythritol triacrylate and trimethylolethane dimethacrylate disclosed in German Patent No. 1,267,574). Further, each of the compounds, for example, used for the reaction of the polycarbonate diol or copolycarbonate diol, the compound containing two isocyanate groups and the compound containing a hydroxyl group and a acryloyl group in the molecule can be used alone or in combination.

Among the compounds represented by the formula (1), a compound of the formula (1) in which $R^1$ and $R^5$ are hydrogen atoms, $R^2$ and $R^4$ are ethylene groups $R^3$ is a divalent residue of a copolycarbonate diol of which hydroxyl groups are detached from the both ends and said copolycarbonate diol being constracted with pentamethylene carbonate and hexamethylene carbonate in the ratio of 5/5 (the former/the latter) as repeating units, A is a 1-methylene-1,3,3-trimethylcyclohexane-5-yl group, x and z are 1, respectively, and y is 3-13, more preferably 3, is preferred. As commercial products, there are, for example, UF-7003 and UF-8003 (trade names of products manufactured by Kyoeisha Kagaku Co.). Among then, UF-8003 is preferred.

The compounds represented by the formula (1) can be used alone or as a mixture of two or more of them.

It is preferred to further add at least one polymerizable compound represented by the formula (2) into the component (a):

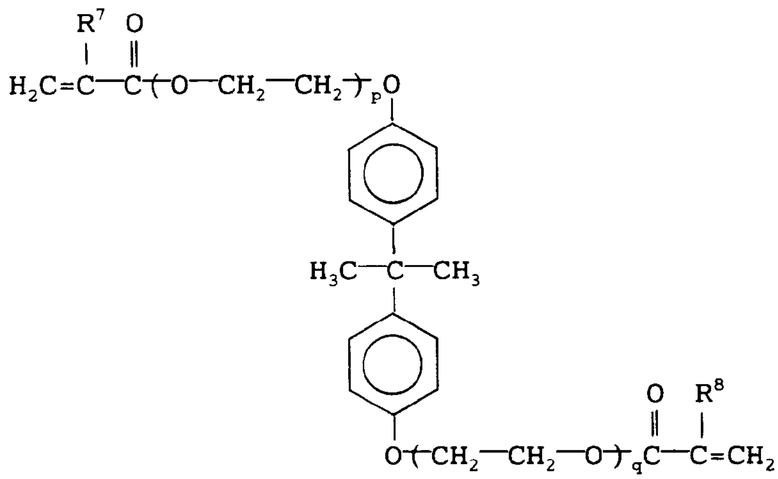

(2)

wherein $R^7$ and $R^8$ each represents independently a hydrogen atom or a methyl group; and p and q each represents an integer so as to make p + q = 4 to 30.

The polymerizable compound represented by the formula (2) includes, for example, 2,2'-bis(4-methacryloxy pentaethoxyphenyl)propane, 2,2'-bis(4-acryloxy pentaethoxyphenyl)propane and 2,2'-bis(4-methacryloxy tetraethoxyphenyl)propane, and commercial products can include, for example, NK ester BPE-500 (trade name of products manufactured by Shin Nakamura Kagaku Kogyo Co.). Among the above polymerizable compounds, BPE-500, namely, a compound represented by the formula (2) in which $R^7$ and $R^8$ are methyl groups and p and q make 10 is preferred.

The polymerizable compounds represented by the formula (2) may be used alone or as a mixture of two or more of them. When p + q is less than 4, flexibility is lowered, while when it exceeds 30, hydrophilicity of the system is increased to reduce the adhesion upon development.

As the component (a), it is also possible to use at least one polymerizable compound having a boiling point of 100°C higher than under a normal pressure other than compounds of the formulae (1) and (2). As such a compound, there can be used, for example, acrylic acid, acrylic esters such as methyl acrylate, ethyl acrylate, n-propyl acrylate, isopropyl acrylate, n-butyl acrylate, isobutyl acrylate, cyclohexyl acrylate, benzyl acrylate, carbitol acrylate, methoxyethyl acrylate, ethoxyethyl acrylate, butoxyethyl acrylate, hydroxyethyl acrylate, hydroxypropyl acrylate, butyleneglycol monoacrylate, N,N-dimethylaminoethyl acrylate, N,N-diethylaminoethyl acrylate, glycidyl acrylate, tetrahydrofurfuryl acrylate, pentaerythritol monoacrylate, trimethylolpropane monoacrylate, allyl acrylate, 1,3-propyleneglycol diacrylate, 1,4-butylene glycol diacrylate, 1,6-hexyleneglycol diacrylate, neopentylglycol diacrylate, dipropyleneglycol diacrylate, 2,2-bis(4-acryloxydiethoxyphenyl)propane, 2,2-bis(4-acryloxypropylxyphenyl)propane, trimethylolpropane diacrylate, pentaerythritol diacrylate, trimethylolpropane triacrylate, pentaerythritol triacrylate, triacrylformal, tetramethylolmethane tetraacrylate and tris(2-hydroxyethyl)isocyanurate, a compound represented by the following formula:

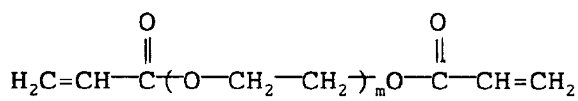

(in which m is a positive integer of 1 to 30), methacrylic acid, methacrylic esters such as methyl methacrylate, ethyl methacrylate, propyl methacrylate, isopropyl methacrylate, butyl methacrylate, isobutyl methacrylate, cyclohexyl methacrylate, benzyl methacrylate, octyl methacrylate, ethylhexyl methacrylate, methoxyethyl methacrylate, ethoxyethyl methacrylate, butoxyethyl methacrylate, hydroxyethyl methacrylate, hydroxypropyl methacrylate, hydroxybutyl methacrylate, hydroxypentyl methacrylate, N,N-dimethylamino methacrylate, N,N-diethylamino methacrylate, glycidyl methacrylate, tetrahydrofurfuryl methacrylate, methacryloxypropyltrimethoxy silane, allyl methacrylate, trimethylolpropane monomethacrylate, pentaerythritol monomethacrylate, 1,3-butyleneglycol dimethacrylate, 1,6-hexyleneglycol dimethacrylate, neopentylglycol dimethacrylate, 2,2-bis(4-methacryloxydiethoxyphenyl)propane, trimethylolpropane trimethacrylate, pentaerythritol trimethacrylate, tetramethylolmethane tetramethacrylate and tris(2-hydroxyethyl)isocyanurate, a compound represented by the following formula:

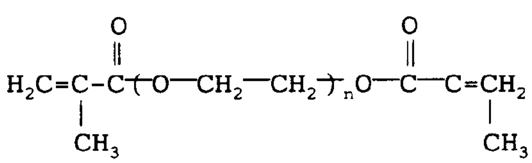

in which n is a positive integer of 1 to 30, trimethylhexamethylene diisocyanate/2-hydroxyethyl acrylate (1/2 molar ratio) reaction product, isocyanateethyl methacrylate/water (2/1 molar ratio) reaction product, butyl crotonate, glycerine monocrotonate, vinyl butyrate, vinyltrimethyl acetate, vinyl caproate, vinylchlor acetate, vinyl lactate, vinyl benzoate, divinyl succinate, divinyl phthalate, methacrylamide, N-methylmethacrylamide, N-ethylmethacrylamide, N-arylmethacrylamide N-hydroxyethyl-N-methyl methacrylamide, acrylamide, N-t-butylacrylamide, N-methylol acrylamide, N-isobutoxymethyl acrylamide, N-butoxymethyl acrylamide, diacetone acrylamide, hexylvinyl ether, ethylhexyl vinyl ether, vinyl triether, polyvinyl ether of polyhydric alcohols, styrene derivatives, for example, styrene having one or more substituents such as an alkyl group, an alkoxy group, halogen, a carboxyl group and an allyl group, for example, at ortho and/or para positions, divinylbenzene, allyloxyethanol, diallylester of dicarboxylic acid, N-vinyloxazolidone, N-vinylimidazol, N-vinylpyrrolidone and N-vinylcarbazol.

The blending amount of the ethylenically unsaturated group-containing polymerizable compound including the polymerizable compound represented by the formula (1) is preferably from 10 to 70% by weight based on the total amount of the components (a) and (b). When the amount is less than 10% by weight, the flexibility as the cover layer tends to be insufficient and, when it exceeds 70% by weight, the soldering heat resistance tends to be reduced. The blending amount of the polymerizable compound represented by the formula (1) is preferably 25% by weight or more based on the amount of the component (a) in view of the flexibility, and the like. The blending amount of the polymerizable compound represented by the formula (2) is preferably from 5 to 60% by weight based on the amount of the component (a) in a state of blending the polymerizable compound represented by the formula (1) by a required amount in view of the flexibility. If it is less than 5% by weight, further improvement of the flexibility, the soldering heat resistance or the like may not be expected and, if it exceeds 60% by weight, the flexibility tends to be reduced.

The polymerizable compound of the formula (1) can be prepared by conventional processes disclosed, for example, in JP-B 61-49329, JP-A 56-28213 and JP-A H6-166737.

The photosensitive resin composition according to the present invention contains a thermoplastic polymer having carboxyl groups as the essential component (b). The thermoplastic polymer preferably has a weight average molecular weight of 20,000 to 300,000. Further, those having carboxyl group content of 15 to 50 mol% are preferred and two or more of them may be used together. Further, while it is preferred that the thermoplastic polymer is soluble or swellable in an aqueous alkali solution, it sufficies that it is soluble as a photosensitive resin composition to the aqueous alkali solution.

As the thermoplastic polymer (b) having the carboxyl groups, a vinyl copolymer is preferred, and copolymerizable monomers usable for the vinyl copolymer can include, for example, a mixture of acrylic acid and/or methacrylic acid, and methyl methacrylate, butyl acrylate, butyl methacrylate, 2-ethylhexyl methacrylate, lauryl methacrylate, ethyl acrylate, methyl acrylate, styrene, a-methylstyrene, vinyltoluene, N-vinylpyrrolidone, 2-hydroxyethyl methacrylate, 2-hydroxyethyl acrylate, acrylamide, acrylonitrile, methacrylonitrile, dimethylaminoethyl methacrylate and dimethylaminoethyl acrylate.

The above vinyl copolymer can be obtained by reacting the above copolymerizable monomers in the solvent, for example, ketones such as acetone and methyl ethyl ketone, aromatic hydrocarbons such as toluene, polyvalent alcohols such as ethylen glycol and propylene glycol and derivatives thereof at 60-80°C for 2-15 hours, under a reactive catalyst, for example, peroxides such as benzoyl peroxide, and azobisisobutyronitrile, thereby replacing oxygen in the reaction system with nitrogen. Further, half esters of styrene/maleic acid copolymers or the like can also be used.

Among the above thermoplastic polymer (b), a copolymer of methacrylic acid/methyl methacrylate/butyl acrylate in a ratio of 22/57/21 (% by weight) is more preferred.

The blending amount of the component (b) is preferably from 30 to 70% by weight based on the total amounts of the components (a) and (b). When the amount is less than 30% by weight, alkali developing property tends to be reduced, and the photosensitive resin composition layer is softened when it is formed into a photosensitive film tending, to ooze out from the film end face. Further, when the amount exceeds 70% by weight, it tends to reduce the sensitivity and reduce the solder heat resistance.

The photosensitive resin composition according to the present invention contains, as the essential component (c), a photopolymerization initiator capable of generating free radicals upon exposure to actinic light. The photopolymerization initiator usable herein can include, for example, substituted or non-substituted polynucleic quinones such as 2-ethylanthraquinone, 2-t-butylanthraquinone, octamethyl anthraquinone, 1,2-benzanthraquinone and 2,3-diphenylanthraquinone, α-hydrocarbon substituted aromatic acyloins such as α-phenylbenzoin, α,α-diethoxyacetophenone, aromatic ketones such as benzophenone and 4,4'-bisdialkylaminobenzophenone such as 4,4'-bisdiethylaminobenzophenone, thioxanthones such as 2-methylthioxanthone, 2,4-diethylthioxanthone, 2-chlorothioxanthone, 2-isopropylthioxanthone and 2-ethylthioxanthone, 2-methyl-1-(4-(methylthio)phenyl)-2-morpholino-propanone-1, which may be used alone or as a mixture of two or more of them. Among the above component (c), a mixture of benzophenone and 4,4'-bisdiethylaminobenzophenone is preferred.

The blending amount of the component (c) is preferably from 0.01 to 20% by weight based on the total amount of the components (a) and (b) in view of the sensitivity.

In the photosensitive resin composition of the present invention, one or more thermosetting components such as a melamine resin, dyes, pigments, plasticizers and stabilizers may be further added as required.

The photosensitive resin composition of the present invention can also be used for producing a photosensitive film by coating the composition on a support film, followed by drying. As the support, a polymer film, for example, a film made from polyethylene terephthalate, polypropylene or polyethylene can be used. Among them, polyethylene terephthalate is preferred. Since it is necessary to remove the polymer film from the photosensitive layer in a later stage, the polymer film should not be subjected to a surface treatment or should

not be made from a material that prevents from removing the polymer film in order to make the removal easy. The thickness of the polymer film is usually from 5 to 100 μm, preferably from 10 to 30 μm. The polymer film may be laminated on both surfaces of the photosensitive layer, one as a support film for the photosensitive layer and the other as a protective film for the photosensitive layer.

In the production of the photosensitive film, the photosensitive resin composition comprising the components (a) to (c) is uniformly dissolved in a solvent. Any of solvents capable of dissolving the photosensitive resin composition may be used as the solvent. Examples of the solvents are ketone type solvents such as acetone, methyl ethyl ketone and methyl isobutyl ketone; ether type solvents such as methyl Cellosolve and ethyl Cellosolve; chlorinated hydrocarbon type solvents such as dichloromethane and chloroform; and alcohol type solvents such as methanol and ethanol. These solvents can be used alone or as a mixture of two or more of them.

After uniformly coating the photosensitive resin composition in a solution form on the polymer film as the support film layer, the solvent is removed by heating and/or hot air blowing to form a dried film. There may not be particular restriction on the thickness of the dried film but the film thickness is usually from 10 to 100 μm, preferably from 20 to 60 μm.

The thus obtained photosensitive film of the present invention comprising the two layers of the photosensitive layer and the polymer film can be taken up into a rolled form as it is or further laminated with a protective film on the other surface of the photosensitive layer and stored.

When photoresist images are formed by using the photosensitive film of the present invention, lamination is carried out by press bonding the photosensitive layer to a substrate with heating after removing the protective film, if it is present. More preferably, the lamination is carried out under a reduced pressure. The surface on which lamination is applied is usually that of FPC having wirings by etching or the like, but there may not be particular restriction thereon. Heating and press bonding of the photosensitive layer are conducted usually at 90 - 130°C, at a bonding pressure of $2.94 \times 10^5$ Pa (3 kgf/$cm^2$) under a reduced pressure of 4000 Pa (30 mmHg) or less, but may not be limited thereto. When the photosensitive film of the present invention is used, preheating for the substrate is not necessary if the photosensitive layer is heated as described above. A preheating treatment may be applied to the substrate for further improving the lamination property.

After completion of the lamination, the resulting photosensitive layer is exposed to actinic light imagewisely by using a negative or positive working film. In this case, if the polymer film present on the photosensitive layer is transparent, the exposure to light can be carried out as it is. If the polymer film is not transparent, it is naturally necessary to remove it. With a viewpoint of protecting the photosensitive layer, it is preferred that the polymer film is transparent and the exposure is applied to the polymer film while leaving it as it is. As the actinic light, light emitted from a known actinic light source, for example, carbon arc, mercury vapor arc, xenone arc or the like can be used. The sensitivity of the photo initiator contained in the photosensitive layer is usually at the maximum in a UV-ray region. In such a case, the actinic light source should be such one as effectively emitting UV-rays.

After exposure to light, if the polymer film is present on the photosensitive layer, it is removed physically, for example, by hand, and then development is carried out by using an aqueous alkaline solution while removing a non-exposed area by a conventional method, for example, spraying, dipping with shaking, brushing, or scrubbing.

For preparing the aqueous alkali solution, there can be used a base, for example, an alkali hydroxide such as lithium, sodium or potassium hydroxide; an alkali carbonate such as lithium, sodium or potassium carbonate or bicarbonate; an alkali metal phosphate such s potassium phosphate or sodium phosphate, an alkali metal pyrophosphate such as sodium pyrophosphate or potassium pyrophosphate. Among them, an aqueous solution of sodium carbonate is particularly preferred. The pH of the aqueous alkali solution used for the development is preferably between 9 and 11, and the temperature thereof is adjusted in accordance with the developing property of the photosensitive layer. The aqueous alkali solution, may further contain one or more surface active agents, defoamers, and a small amount of organic solvents for promoting development.

Further, in order to improve the heat resistance, chemical resistance or the like as a cover layer for FPC, UV-ray irradiation using a high pressure mercury lamp, and/or heating can be applied after the development. The irradiation dose of UV-rays used is generally about 0.2 to 10 J/$cm^2$ and it is preferred that irradiation is accompanied by heating at 60 - 150°C. Heating is applied within a range of about 100 - 170°C for about 15 to 90 minutes. The order of the UV-ray irradiation and heating is optional and there is no problem which is applied first.

After providing properties of the cover layer in this way, electronic parts such as LSI and the like are mounted thereon (by soldering) and installing in an equipment such as a camera is conducted.

The present invention is illustrated by way of the following Examples, in which all percents and parts are by weight unless otherwise specified.

Example 1

A solution (Solution A) having a composition as shown in Table 1 was uniformly coated on a polyethylene terephthalate film of 25 μm thick by using an apparatus shown in Fig. 1, and dried by a hot air blow circulating drier 7 at 100°C for about 5 minutes to remove the solvent. In Fig. 1, numeral 1 denotes polyethylene terephthalate film delivery roll, numerals 2, 3, 4, 9 and 10 are rolls, numeral 5 denotes a knife, numeral 6 denotes the solution of photosensitive resin composition, numeral 8 denotes a polyethylene film delivery roll, numeral 11 denotes a photosensitive film taking up roll, numeral 12 denotes polyethylene terephthalate and numeral 13 denotes polyethylene. The thickness of the photosensitive layer after drying was about 50 μm.

TABLE 1 Composition of Solution A

| Material | Blending amount (parts) |
|---|---|
| 40% methyl Cellosolve solution of a copolymer of methacrylic acid/ methyl methacrylate/butyl acrylate = 22/71/7 (%) (weight average molecular weight: about 80,000) | 125.0 |
| UF-8003 (a trade name, manufactured by Kyoeisha Chemical Co.; 80% methyl ethyl ketone solution of the compound of the formula (1) in which $R^1$ and $R^5$ are hydrogen atom; $R^2$ and $R^4$ are ethylene groups, $R^3$ is a divalent residue*1, A is an isophorone *2 group, x, z are each 1, and y is 3-13; Weight average molecular weight: 13,500 | 62.5 |
| BPE-500 (a trade name, manufactured by Shin-Nakamura Chemical Industry Co.; methacrylate of ethyleneoxide addition product of bisphenol A. A compound of the formula (2) in which $R^7$ and $R^8$ are methyl groups, p+q is 10) | 20.0 |

*1 = a divalent residue of a copolycarbonate diol, of which hydroxyl groups are detached from the both ends and said copolycarbonate diol being constructed with pentamethylene carbonate and hexamethylene carbonate in the ratio of 5/5 (the former/the latter) as repeating units

*2 = 1-methylene-1,3,3-trimethylcyclohexane-5-yl

TABLE 1 (Cont'd)

| Material | Blending amount (parts) |
|---|---|
| Hexamethoxymethylmelamine | 10.0 |
| Diethylaminobenzophenone | 0.1 |
| Benzophenone | 5.0 |
| Victoria pure blue | 0.2 |
| Methyl ethyl ketone | 45.0 |

Then, a polyethylene film was further laminated on the photosensitive layer by using the apparatus shown in Fig. 1, to obtain photosensitive film.

Separately, a copper surface of a FPC substrate obtained by laminating a copper foil of 35 μm thick on a polyimide substrate (F30VC125RC11, a trade name, manufactured by Nikkan Kogyo Co.) was polished with a granular grinding particle brush, washed with water and dried. The photosensitive film was laminated on the substrate (at 23°C) by using a vacuum laminator (Model VLM-1, a trade name, manufactured by Hitachi Chemical Company, Ltd.) at a heat shoe temperature of 110°C, under an air pressure of 4000 Pa (30 mmHg) or lower, and under a lamination pressure of $2.94 \times 10^5$ Pa (3 kgf/cm$^2$).

Then, the resultant specimen was exposed to light using a 21 step tablet of Stouffer and a negative film of linear lines with 150 μm/150 μm line/space by an exposure machine model HMW-201B manufactured by ORC Seisakusho, Ltd. at 200 mJ/cm$^2$ and allowed to stand at room temperature for 30 min. Then, spray development was applied at 30°C for 100 seconds using an aqueous 1% solution of sodium carbonate. Number of steps is shown for residual step tablets. Then, a heat treatment at 150°C for 45 minutes was conducted. Further, UV-ray irradiation was applied by using a UV-ray irradiation apparatus manufactured by Toshiba Denzai Co. (rated voltage: 200 V, rated power consumption: 7.2 kW, H5600L/2 x one lamp) at 3 J/cm$^2$ to obtain a cover layer corresponding to the negative film.

When the specimen was bent by 180° for the evaluation of flexibility, no abnormality such as cracks was found at all in the cover layer. Then, when soldering was applied at 260°C for 10 seconds using a rosin type CRACK MH-820V (a trade name, manufactured by Tamura Kaken Co.) to observe soldering heat resistance, there was no abnormality such as blister. Further, when bending at 180° was applied for the evaluation of flexibility, no abnormality such as cracks was found in the cover layer. Table 2 shows the results of the evaluations.

Examples 2 - 3 and Comparative Examples 1 - 3

The polymerizable compounds used as component (a) used in Example 1 were replaced with compounds shown in Table 2, and the other compounds (including component (b) in the same amount) were blended in the same manner as in Example 1. Further, in the same manner as in Example 1, the films were fabricated as cover layers and evaluated. Table 2 collectively shows the results.

Reference symbols in Table 2 mean the following polymerizable compounds.

UF-7003 (a trade name, manufactured by Kyoeisha Kagaku Co.; 80% methyl ethyl ketone solution of a compound having weight average molecular weight of 13,000 and represented by the formula (1) in which $R^1$ and $R^5$ are hydrogen atoms; $R^2$ and $R^4$ are ethylene groups; $R^3$ is a divalent residue of a copolycarbonate diol, of which hydroxyl groups are detached from the both ends and said copolycarbonate diol being constructed with tetramethylene carbonate and hexamethylene carbonate in the ratio of 5/5 (the former/the latter) as repeating units; A is a 1-methylene-1,3,3-trimethylcyclohexane-5-yl group; x and z are 1, and y is 3-13).

A-TMPT (a trade name of trimethylolpropane triacrylate, manufactured by Shin-Nakamura Kagaku Kogyo co.)

TMCH (an addition product of 2,2,4-trimethylhexamethylene-1,6-diisocyanate and 2-hydroxyethyl acrylate at 1:2 molar ratio)

TABLE 2

(unit: parts)

| Item | Example 1 | Example 2 | Example 3 | Comp. Example 1 | Comp. Example 2 | Comp. Example 3 |
|---|---|---|---|---|---|---|
| UF-8003 | 62.5 | 50 | - | 50 | - | 100 |
| UF-7003 | - | - | 62.5 | - | - | - |
| BPE-500 | 20 | 30 | 30 | - | 20 | - |
| A-TMPT | - | - | - | 30 | - | - |
| TMCH | - | - | - | - | 30 | - |
| Number of residual steps | 7 | 7 | 7 | 7 | 7 | - |
| Soldering heat resistance (260°C, 10 sec) | Good | Good | Good | Good | Good | Blisters |
| Flexibility (180°)<br>Before soldering<br>After soldering | <br>Good<br>Good | <br>Good<br>Good | <br>Good<br>Good | <br>Cracked<br>Cracked | <br>Cracked<br>Cracked | <br>Good<br>Good |

As is clear from Table 2, it is shown that cover layers excellent in both the soldering heat resistance and the bendability (flexibility) can be obtained in the case of using the photosensitive resin composition of the

present invention.

According to the photosensitive resin composition and the photosensitive film using the composition of the present invention, a cover layer for FPC excellent in solder heat resistance and bendability (flexibility), can be obtained resulting in making it possible to facilitate the fabrication of the cover layer easily with a high yield and high producting overcoming drawbacks of prior art, i.e. a lower yield or low productivity so far caused by manual operation. Thus, the recent demand for higher density can be accomplished.

## Claims

1. A photosensitive resin composition developable with an aqueous alkali solution, said composition comprising
   (a) at least one ethylenically unsaturated group-containing polymerizable compound including at least one polymerizable compound represented by the formula:

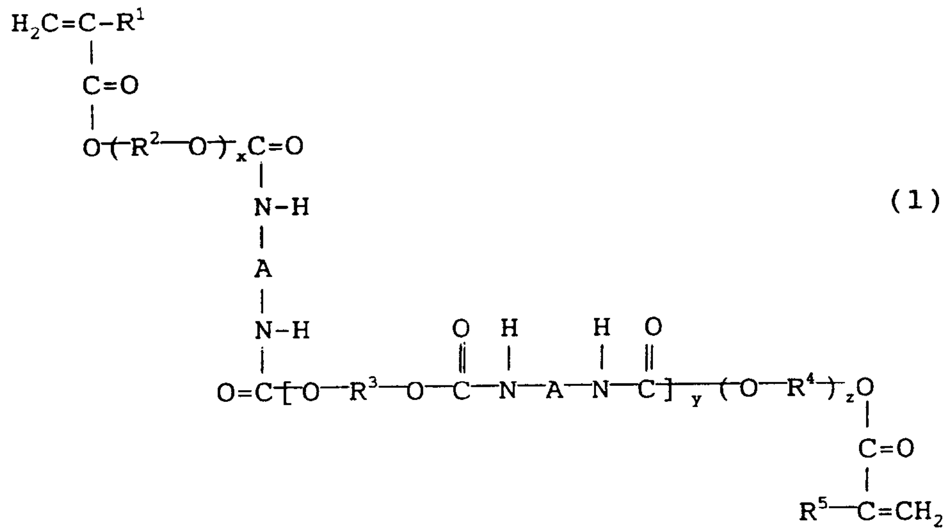

(1)

   wherein A represents an alkylene group having 2 to 12 carbon atoms, a vinylene group, a 1-methylene-1,3,3-trimethylcyclohexane-5-yl group, or a group of the formula:

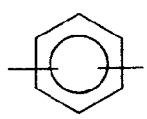
,
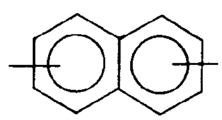
,

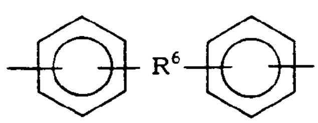
or
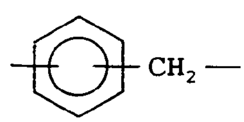

   in which $R^6$ represents a methylene group or an imino group; $R^1$ and $R^5$ each represents independently a hydrogen atom or a methyl group, respectively; $R^2$, and $R^4$ each represents independently an alkylene group having 2 to 8 carbon atoms; $R^3$ represents a divalent residue of a polycarbonate diol or copolycarbonate diol, of which hydroxyl groups are detached from the both ends; x and z each represents independently an integer of 1 to 20; and y represents an integer of 1 to 100,
   (b) a thermoplastic polymer having carboxyl groups, and
   (c) a photopolymerization initiator capable of generating free radicals upon exposure to actinic light.

2. The photosensitive resin composition according to Claim 1, which further comprises as the component (a) at least one polymerizable compound of the formula:

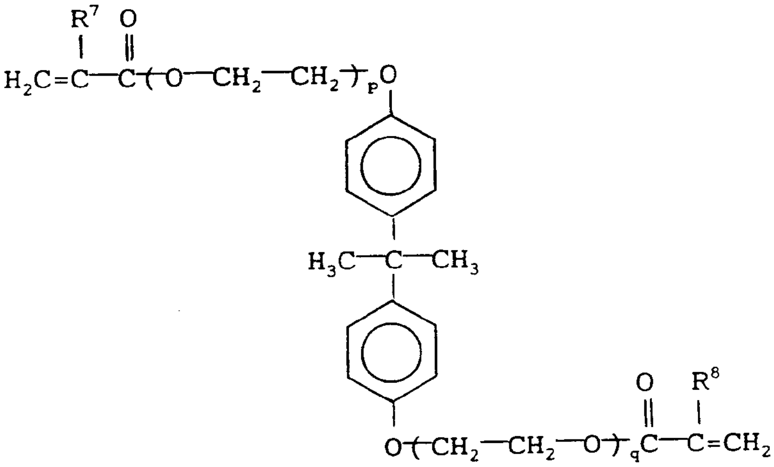

(2)

wherein $R^7$ and $R^8$ each represents independently a hydrogen atom or a methyl group; and p and q each represents a positive integer selected such that p + q is 4 to 30.

**3.** The photosensitive resin composition according to Claim 2, wherein $R^7$ and $R^8$ are methyl groups; and p and q make 10.

**4.** The photosensitive resin composition according to any one of the preceding claims, wherein the polymerizable compound is the compound represented by the formula (1) in which $R^1$ and $R^5$ are hydrogen atoms; $R^2$ and $R^4$ are ethylene groups; $R^3$ is a divalent residue of a copolycarbonate diol of which hydroxyl groups are detached from the both ends and said copolycarbonate diol being constructed with pentamethylene carbonate and hexamethylene carbonate in the ratio of 5/5 (the former/the latter) as repeating units; A is a 1-methylene-1,3,3-trimethylcyclohexane-5-yl group; x and z are 1; and y is 3-13.

**5.** The photosensitive resin composition according to any one of the preceding Claims, wherein the thermoplastic polymer (b) is a copolymer of methacrylic acid/methyl methacrylate/butyl acrylate in a weight ratio of 22/57/21.

**6.** The photosensitive resin composition according to any one of the preceding Claims, wherein the photopolymerization initiator (c) is a mixture of benzophenone and 4,4'-bisdiethylaminobenzophenone.

**7.** A photosensitive film comprising a support film and a layer of a photosensitive resin composition as claimed in any one of the preceding Claims formed on the support film.

**8.** Use of a photosensitive resin composition as claimed in any one of Claims 1 to 6, in the formation of a photoresist image.

FIG. 1

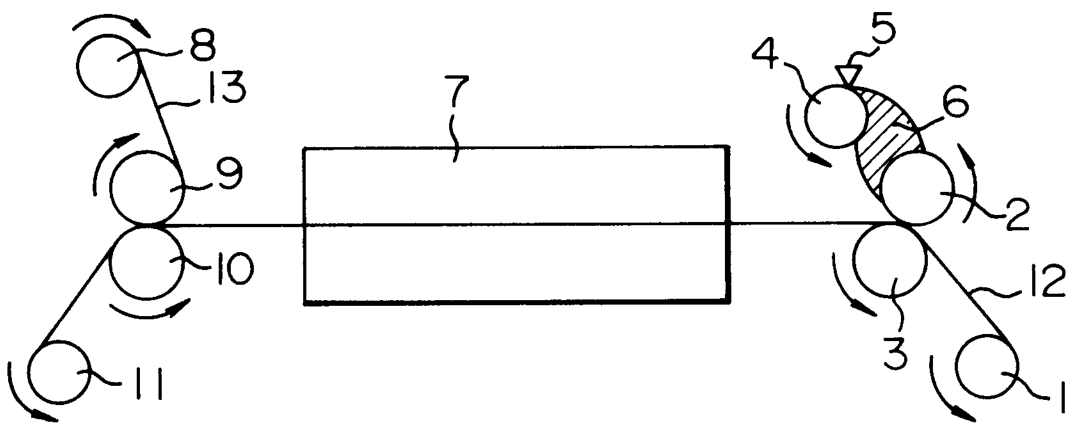

European Patent Office

# EUROPEAN SEARCH REPORT

Application Number
EP 95 30 1656

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | EP-A-0 230 939 (DESOTO, INC.) 5 August 1987<br>* examples 1-3 * | 1,5-8 | G03F7/027<br>C08G18/44 |
| Y | EP-A-0 005 750 (HOECHST AKTIENGESELLSCHAFT) 12 December 1979<br>* page 11, line 5 - line 27 *<br>* page 17, line 5 - line 8 * | 1,5-8 | |
| A | EP-A-0 382 524 (MITSUBISHI RAYON CO.) 16 August 1990<br>* page 8, line 24 - line 28 *<br>* page 11; table 1 * | 1-8 | |
| A | EP-A-0 141 330 (DESOTRO, INC.) 15 May 1985<br>* examples 1-3 * | 1-8 | |

TECHNICAL FIELDS SEARCHED (Int.Cl.6)

G03F
C08G

The present search report has been drawn up for all claims

| Place of search | Date of completion of the search | Examiner |
|---|---|---|
| THE HAGUE | 13 July 1995 | J.-M. DUPART |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)